# EUROPEAN PATENT APPLICATION

(11) **EP 4 641 850 A1**
(43) Date of publication of application: **29.10.2025**
(21) Application number: 22968941.9
(22) Date of filing: 22.12.2022
(51) Int. Cl.: H01S 5/40, G01S 7/481

(54) **EMITTING DEVICE, DETECTION DEVICE, AND TERMINAL**

(71) Applicant: Shenzhen Yinwang Intelligent Technologies Co., Ltd., Shenzhen, Guangdong 518110 (CN)
(72) Inventor: XIAO, Xisheng, Shenzhen, Guangdong 518129 (CN); LIU, Jun, Shenzhen, Guangdong 518129 (CN)
(74) Representative: Pfenning, Meinig & Partner mbB
(86) International application number: PCT/CN2022/141026
(87) International publication number: WO 2024/130643

(57) **Abstract**

An emitting apparatus, a detection apparatus, and a terminal are provided, and may be used in fields such as detection, intelligent surveying and mapping, and intelligent driving. The emitting apparatus includes a first emitting module, a second emitting module, a circuit board, and a first optical module. The first emitting module and the second emitting module are electrically connected to the circuit board, and are disposed on one side of the circuit board. The first optical module is placed between the first emitting module and the second emitting module. The first emitting module and the second emitting module emit light beams in different directions, and the first optical module may deflect a direction of a light beam from the first emitting module, so that light sources in different out-light directions emit light in a same direction. Further, a first module is disposed between the first emitting module and the second emitting module. Therefore, a distance between a deflected light beam and a light beam from the second emitting module is shorter. **In** this way, an out-light gap between emitting apparatuses in a case in which a plurality of light sources emit light is reduced, and a visual blind spot is reduced.

## Description

### TECHNICAL FIELD

This application relates to detection technologies, and in particular, to an emitting apparatus, a detection apparatus, and a terminal, and is used in fields such as intelligent driving, intelligent transportation, surveying and mapping, and intelligent manufacturing.

### BACKGROUND

With development of information technologies, detection technologies develop rapidly, and various detection apparatuses bring great convenience to people's life and travel. For example, an advanced driver assistance system (advanced driver assistance system, ADAS) plays a very important role in intelligent vehicles. The advanced driver assistance system uses a detection apparatus mounted on the vehicle to detect an ambient environment, collect data, identify static or moving objects, and the like in a traveling process of the vehicle and perform systematic calculation and analysis based on map data of a navigator, so that a driver is aware of potential hazards in advance, and driving comfort and safety of the vehicle are effectively improved. The detection apparatus may be considered as an "eye" for sensing an environment, and includes a vision system sensor like a camera, and a radar system sensor like a millimeter-wave radar, a lidar, and an ultrasonic radar.

The lidar (light detection and ranging, Lidar, or referred to as a light detection and ranging apparatus) has advantages of high resolution, good detection performance, and strong concealment, and is one of important detection apparatuses in the sensing field. The lidar is a technology for emitting a detection signal and obtaining related information (for example, a feature value like a location, a shape, or a speed of a target) of the target by receiving an echo obtained through reflection by the target. A plurality of lasers often need to be disposed at an emit end of the lidar, to improve detection efficiency. However, there is a field of vision gap between light beams emitted by the plurality of lasers, resulting in a discontinuous emitting visual field of the emit end. A gap between fields of vision forms a visual blind spot, which seriously affects detection performance.

How to reduce a visual blind spot of the lidar is an urgent problem to be resolved by a person skilled in the art.

### SUMMARY

Embodiments of this application provide an emitting apparatus, a detection apparatus, and a terminal, so that detection can be performed by using a hybrid light source, a visual blind spot of the detection apparatus is narrowed, and detection performance is enhanced.

According to a first aspect, an embodiment of this application provides an emitting apparatus, including a first emitting module, a second emitting module, a circuit board, and a first optical module;
the first emitting module and the second emitting module are electrically connected to the circuit board, and are disposed on one side of the circuit board, and the first optical module is placed between the first emitting module and the second emitting module;
the first emitting module is configured to emit a first light beam, where the first light beam is parallel to the circuit board;
the second emitting module is configured to emit a second light beam, where a direction of the second light beam diverges away from the circuit board; and
the first optical module is configured to change a direction of the first light beam to obtain a third light beam, where a direction of the third light beam diverges away from the circuit board.

In this embodiment of this application, an out-light direction of the first emitting module is a direction parallel to the circuit board, and an out-light direction of the second emitting module is a direction away from the circuit board. An optical module (which is referred to as a first optical module for ease of differentiation) is disposed between the first emitting module and the second emitting module, to deflect the direction of the first light beam, so that the direction of the first light beam also faces a direction away from the circuit board. In this way, light sources (namely, a hybrid light source) in different out-light directions emit light in a same direction. Further, the first optical module is disposed between the first emitting module and the second emitting module. After the direction of the first light beam is changed by the first optical module, a distance between the third light beam and the second light beam is shorter than a distance between the first emitting module and the second emitting module, so that the distance between the third light beam and the second light beam is shorter. In this way, without reducing the distance between the first emitting module and the second emitting module, an out-light gap between emitting apparatuses in a case in which a plurality of light sources output light can be reduced, a visual blind spot is reduced, detection efficiency is improved, and detection performance is enhanced.

In a possible implementation of the first aspect, the first emitting module includes an edge-emitting laser, and the second emitting module includes a vertical surface emitting laser.

When a vertical surface emitter is disposed on the circuit board, an out-light surface is a surface parallel to the circuit board. Therefore, an out-light direction of the vertical surface emitter is a direction away from the circuit board. The vertical surface emitter includes but is not limited to a vertical cavity surface emitting laser (vertical cavity surface emitting laser, VCSEL), a photonic crystal surface emitting semiconductor laser (photonic crystal surface emitting semiconductor lasers, PCSEL), or the like.

When the edge-emitting laser (edge-emitting laser, EEL) is disposed on the circuit board, an out-light surface is a side surface of the laser. Therefore, an out-light direction of the edge-emitting laser is a direction parallel to the circuit board. Optionally, the EEL may alternatively be another apparatus that emits light at an edge of a light emitting component, for example, a silicon photonic chip.

In another possible implementation of the first aspect, an optical axis of the third light beam is coaxial with an optical axis of the second light beam. Light beams emitted by an emit end are coaxial, so that a diameter of an optical lens can be reduced, complexity of a component design is reduced, and stability of an optical path is improved.

In another possible implementation of the first aspect, an optical axis of the third light beam has a bias toward the first emitting module relative to an optical axis of the second light beam. The third light beam is slightly deflected toward a direction of the first emitting module, so that an included angle between the third light beam and the second light beam can be smaller, or the third light beam and the second light beam are parallel but have a reduced spacing.

In another possible implementation of the first aspect, a distance between the third light beam and the second light beam is less than a distance between the first emitting module and the second emitting module.

In another possible implementation of the first aspect, the emitting apparatus further includes a lens, and the lens is configured to: process the third light beam to obtain a fourth light beam, and process the second light beam to obtain a fifth light beam. The second light beam and the third light beam are emitted by using a same lens, so that a volume of an emitting apparatus can be reduced, and component integration can be improved.

In another possible implementation of the first aspect, the fourth light beam and the fifth light beam have a continuous visual field; or
a visual field gap between the fourth light beam and the fifth light beam is less than a first angle, and the first angle is an included angle between the first emitting module and the second emitting module relative to the lens.

The continuous visual field or a reduced visual field gap may further narrow a visual blind spot, and improve detection efficiency and reliability of a detection result.

In a possible implementation, the visual field gap between the fourth light beam and the fifth light beam is related to a distance between the second emitting module and the first optical module. In such a setting, a visual field gap of the emit end may be controlled by adjusting the distance between the first optical module and the second emitting module. A manufacturer or a developer may flexibly set a location of the first optical module according to a requirement, to improve compatibility of the emitting apparatus with different scenarios.

In another possible implementation of the first aspect, the second emitting module is located on a focal plane of the lens. In this implementation, a light beam emitted by the second emitting module has a good collimation degree when passing through the lens, to improve a longest detection range of a detection apparatus, and ensure a long-range detection capability.

In another possible implementation of the first aspect, the first optical module includes a reflective surface, the reflective surface is configured to change the direction of the first light beam to obtain the third light beam, and a mirror surface of the first reflective surface is a convex spherical surface. The convex spherical surface is used to compensate for a relative defocusing amount of the first emitting module, to improve a collimation degree of the third light beam, and improve a long-range detection capability.

Optionally, the defocusing amount of the first emitting module is related to a distance between the first optical module and the first emitting module. In such a setting, the distance between the first optical module and the first emitting module is adjusted, so that the defocusing amount of the first emitting module can be controlled. The manufacturer or the developer may flexibly set the location of the first optical module according to a requirement, to improve compatibility of the emitting apparatus with different scenarios.

In another possible implementation of the first aspect, a longest detection range of the first light beam is less than a longest detection range of the second light beam. In such a setting, the light beam emitted by the second emitting module may detect a blind spot formed during long-range detection, to improve a short-range detection capability of the detection apparatus, and enhance detection performance of the detection apparatus.

In another possible implementation of the first aspect, the first emitting module and the second emitting module are configured to emit light beams in a time division manner, and the first light beam and the second light beam have different transmission time. In such a setting, transmission time of the first light beam and transmission time of the second light beam are alternate, so that it is difficult to form mutual interference when targets in different visual fields are detected.

In another possible implementation of the first aspect, the first emitting module is configured to emit the first light beam in a first time period;
the second emitting module is configured to emit the second light beam in a second time period, where the first time period and the second time period do not overlap; and
the second emitting module is further configured to emit a sixth light beam in the first time period, where a longest detection range of the sixth light beam is less than a longest detection range of the second light beam.

In this implementation, time of long-range detection and time of short-range detection are isolated, and short-range detection in a larger range is further implemented. This further improves detection efficiency, improves the short-range detection capability of the detection apparatus, and enhances detection performance.

In another possible implementation of the first aspect, the first emitting module includes N first lasers, the second emitting module includes M second lasers, N and M are integers, N>0, and M>0;
the first emitting module and the second emitting module are distributed along a first direction;
the first emitting module includes N first lasers, the second emitting module includes M second lasers, N and M are integers, N>1, and M>1;
the N first lasers are spaced apart in a second direction, and the second direction is perpendicular to the first direction;
the N second lasers are spaced apart in the second direction; and
the emitting apparatus further includes a light homogenizing component, and the light homogenizing component is configured to perform homogenizing on a light beam from the first emitting module and a light beam from the second emitting module in the second direction.

According to a second aspect, an embodiment of this application further provides a detection apparatus. The detection apparatus includes an emitting apparatus and a detector, and the laser emitter includes the emitting apparatus described in any one of the first aspect or the possible implementations of the first aspect.

A first emitting module in the emitting apparatus is configured to emit a first light beam, and a second emitting module in the emitting apparatus is configured to emit a second light beam.

The detector is configured to receive an echo signal corresponding to the first light beam and an echo signal corresponding to the second light beam.

According to a third aspect, an embodiment of this application further provides a terminal. The terminal includes the emitting apparatus described in the first aspect or any implementation of the first aspect, or includes the detection apparatus described in the second aspect.

Optionally, the terminal may be an intelligent terminal such as a vehicle, an uncrewed aerial vehicle, or a robot, or a transportation tool.

For some beneficial effects of the second aspect and the third aspect of this application, refer to the beneficial effects of the first aspect. Details are not described herein again.

### BRIEF DESCRIPTION OF DRAWINGS

The following briefly describes accompanying drawings used in descriptions of embodiments.
FIG. 1 is a diagram of an emitting field of vision and a receiving field of vision of a detection apparatus;
FIG. 2 shows an emit end including a plurality of light sources;
FIG. 3 is a diagram of an optical path of an emit end;
FIG. 4 is a diagram of a structure of an emitting apparatus according to an embodiment of this application;
FIG. 5 is a diagram of a field of vision of an emit end according to an embodiment of this application;
FIG. 6 is a diagram of a structure of another emitting apparatus according to an embodiment of this application;
FIG. 7 is a diagram of a structure of another emitting apparatus according to an embodiment of this application;
FIG. 8 is a diagram of a structure of another emitting apparatus according to an embodiment of this application;
FIG. 9 is a diagram of a light beam distance according to an embodiment of this application;
FIG. 10 is a diagram of another light beam distance according to an embodiment of this application;
FIG. 11 is a diagram of an optical path according to an embodiment of this application;
FIG. 12 is a diagram of a structure of another emitting apparatus according to an embodiment of this application;
FIG. 13 is a diagram of a structure of another emitting apparatus according to an embodiment of this application;
FIG. 14 is a diagram of a detection range according to an embodiment of this application;
FIG. 15 is a diagram of a light emitting time sequence according to an embodiment of this application;
FIG. 16 is a diagram of another light emitting time sequence according to an embodiment of this application;
FIG. 17 is a diagram of a structure of another emitting apparatus according to an embodiment of this application;
FIG. 18 is a diagram of a structure of a possible emitting apparatus according to an embodiment of this application;
FIG. 19 is a diagram of a structure of another emitting apparatus according to an embodiment of this application;
FIG. 20 is a diagram of a field of view of an emitting apparatus according to an embodiment of this application;
FIG. 21 is a diagram of a structure of another emitting apparatus according to an embodiment of this application;
FIG. 22 is a diagram of a structure of another emitting apparatus according to an embodiment of this application; and
FIG. 23 is a diagram of a structure of another emitting apparatus according to an embodiment of this application.

### DESCRIPTION OF EMBODIMENTS

The following further describes in detail embodiments of this application with reference to accompanying drawings.

For ease of understanding, some concepts related to embodiments of this application are described for reference by using examples below. Details are as follows.

### 1. Detection apparatus

The detection apparatus mentioned in embodiments of this application may be a lidar, or may be another optical detection apparatus, for example, a fusion detection apparatus (for example, a detection apparatus that integrates a radar detector and an image sensor). A working principle of the lidar is to detect a target in a visual field by emitting a detection signal and receiving an echo.

In a possible use scenario, the detection apparatus in embodiments of this application can be used in various fields such as intelligent driving, intelligent transportation, intelligent manufacturing, environmental detection, surveying and mapping, and an uncrewed aerial vehicle, and can complete one or more functions of target detection, range measurement, speed measurement, target tracking, and imaging recognition.

In a possible application location, the detection apparatus in embodiments of this application may be used in a vehicle-mounted detection apparatus (for example, an automotive radar) and a roadside detection apparatus (for example, an intersection radar), and may also be used in another detection apparatus, for example, a detection apparatus mounted on an apparatus such as an uncrewed aerial vehicle, a robot, a rail vehicle, a bicycle, a traffic light, a speed measurement apparatus, or a base station. A mounting location of the detection apparatus is not limited in this application.

### 2. Field of view (field of view, FOV)

A line of sight (line of sight, LOS) area in which transmission of a signal (for example, a radio wave or a laser) is not interrupted is required between an emit end of a detection apparatus and a target object and/or between a receive end of the detection apparatus and the target object. The line of sight area may be understood as a visual field, or referred to as a field of vision.

In some scenarios, an included angle whose vertex is a lens of an optical instrument and that includes two edges of a maximum range in which an object image of a measured target may pass through the lens is referred to as a field of view. The field of view determines a visual field of the optical instrument. A larger field of view leads to a larger visual field.

In embodiments of this application, a field of view in a vertical direction is an included angle including two edges of a maximum range that can be detected in the vertical direction.

The foregoing descriptions of the technical terms are optionally used in the following embodiments.

A detection principle of the detection apparatus is as follows: The emit end emits a detection signal to object space, so that a target in the object space can be illuminated by the detection signal; and the receive end may receive an echo signal formed by reflecting the detection signal on the target, and measure related information of the target based on the echo signal.

Because a power of a signal emitted by the detection apparatus is usually limited, when a target in a long range needs to be detected, the emitted detection signal has a high collimation degree and a small divergence angle. Consequently, the detection signal emitted by the detection apparatus has a poor coverage capability for a short-range area, and there is a large near-field blind spot. Especially when the emit end and the receive end are of an off-axis architecture, the near-field blind spot greatly reduces a short-range detection capability of the detection apparatus.

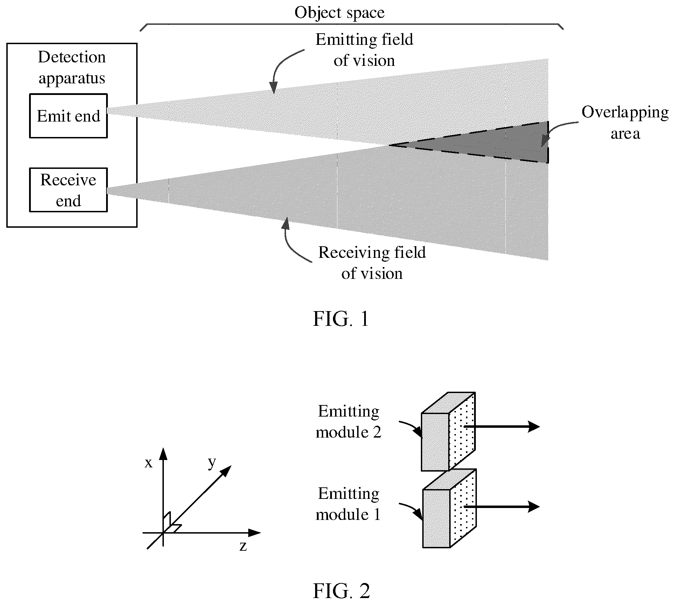

FIG. 1 is a diagram of an emitting field of vision and a receiving field of vision of a detection apparatus. An emit end and a receive end are respectively located at two ends of the detection apparatus, the emitting field of vision is object space covered by a detection signal emitted by the emit end, and the receiving field of vision is object space in which the receive end can receive light. Because the receive end can receive an echo signal of the detection signal only in the object space covered by the detection signal, an overlapping area between the emitting field of vision and the receiving field of vision is an effective detection range of the detection apparatus. It can be learned that a start location of the overlapping area is a location far away from the detection apparatus. In short-range object space before the overlapping area, the receive end cannot receive the echo signal of the detection signal, and a visual blind spot is formed. A larger off-axis degree of the emit end and the receive end leads to a larger near-field blind spot, which affects detection efficiency.

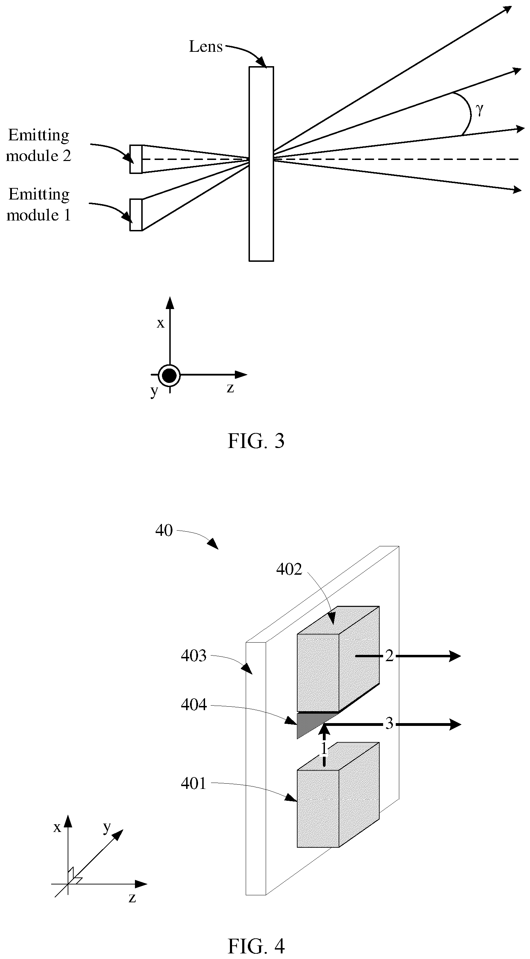

A plurality of laser emitting modules often need to be disposed at the emit end of the detection apparatus, to improve detection efficiency. The plurality of emitting modules may form a plurality of emitting fields of vision, so that detection efficiency can be improved to some extent. FIG. 2 shows an emit end including a plurality of light sources. FIG. 3 is a diagram of an optical path of an emit end. Two emitting modules (namely, an emitting module 1 and an emitting module 2) are disposed at the emit end of the detection apparatus, so that a visual field of the emit end can be enlarged, thereby increasing an effective detection range. However, electrical performance isolation needs to be implemented between emitting modules, so that there is still a gap between the plurality of emitting modules. Therefore, there is still a field of vision gap between light beams emitted by the plurality of emitting modules. As shown in FIG. 3, light beams from the emitting module 1 and the emitting module 2 arrive in a visual field after passing through a lens (a dashed line is an example of a principal axis of the lens). In the visual field, a field of vision gap still exists between the light beams from the emitting module 1 and the emitting module 2, that is, is represented as an included angle γ. Because electrical performance isolation needs to be implemented before the emitting module, the field of vision gap cannot be narrowed by shortening a distance between the two emitting modules. However, the field of vision gap γ makes the visual field of the emit end discontinuous, and a visual blind spot still exists. Consequently, detection performance is affected.

In view of this, embodiments of this application provide an emitting apparatus, a detection apparatus, and a terminal, so that detection can be performed by using a hybrid light source, a visual blind spot of the detection apparatus is narrowed, and detection performance is enhanced.

The following describes in detail solutions in embodiments of this application.

FIG. 4 is a diagram of a structure of a possible emitting apparatus according to an embodiment of this application. An emitting apparatus 40 may include a first emitting module 401, a second emitting module 402, a circuit board 403, and a first optical module 404. The first emitting module 401 and the second emitting module 402 are connected to a same circuit board 403.

The circuit board is a support body of an electronic component. A conductor on the circuit board serves as a line for connecting the electronic component, and includes but is not limited to a printed circuit board (printed circuit board, PCB), a flexible printed circuit board (flexible printed circuit board, FPC), and the like.

Optionally, the first emitting module 401 and the second emitting module 402 may be electronic components, and are electrically connected to the circuit board 403 together.

Alternatively, optionally, electrical performance of the first emitting module 401 and the second emitting module 402 is isolated from that of the circuit board 403. In this case, the first emitting module 401 and the second emitting module 402 may be fastened to the circuit board 403, and are not necessarily electrically connected to the circuit board 403.

Alternatively, the circuit board may alternatively be a substrate, and the substrate may not include a conductor for emitting an electrical signal. The first emitting module and the second emitting module may be fastened to the substrate.

The first emitting module 401 is configured to emit a first light beam. The first light beam is parallel to the circuit board 403. As shown in FIG. 4, the first light beam is represented by an arrow marked 1.

The second emitting module 402 is configured to emit a second light beam. A direction of the second light beam diverges away from the circuit board 403. As shown in FIG. 4, the second light beam is represented by an arrow marked 2. For example, a direction of the second light beam is perpendicular to the circuit board.

The first optical module 404 is configured to change a direction of the first light beam to obtain a third light beam. A direction of the third light beam diverges away from the circuit board. As shown in FIG. 4, the third light beam is represented by an arrow marked 3.

In this embodiment of this application, an out-light direction of the first emitting module is a direction parallel to the circuit board, and an out-light direction of the second emitting module is a direction away from the circuit board. The first optical module is disposed between the first emitting module and the second emitting module, to deflect the direction of the first light beam, so that the direction of the first light beam also faces the direction away from the circuit board. In this way, light sources (namely, a hybrid light source) in different out-light directions emit light in a same direction.

Optionally, the first optical module 404 is disposed between the first emitting module 401 and the second emitting module 402. In this way, after the direction of the first light beam is changed by the first optical module, a distance between the third light beam and the second light beam is shorter than a distance between the first emitting module and the second emitting module, so that the distance between the third light beam and the second light beam is shorter. In this way, without reducing the distance between the first emitting module and the second emitting module, an out-light gap between emitting apparatuses in a case in which a plurality of light sources output light can be reduced, a visual blind spot is reduced, detection efficiency is improved, and detection performance is enhanced. In addition, the first optical module 404 is disposed, so that the distance between the first emitting module 401 and the second emitting module 402 may not be strictly limited. In this way, isolation space of a drive circuit of the light source is larger, and flexibility of a circuit design of the circuit board is improved.

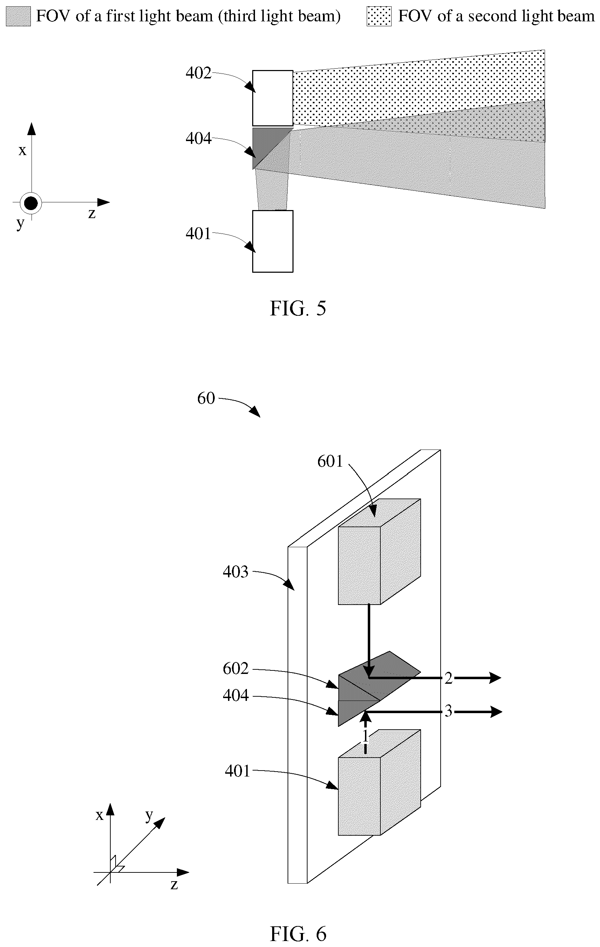

FIG. 5 is a diagram of a field of vision of an emit end according to an embodiment of this application. A third light beam is obtained after the first light beam emitted by the first emitting module 401 is deflected by the first optical module 404. An FOV of the first light beam (the third light beam) is shown by a shadow part. An FOV of the second light beam emitted by the second emitting module 402 is shown by a spot part. It can be learned that the third light beam and the second light beam face a same direction and a distance is greatly shortened, to reduce a visual blind spot.

In conclusion, the emitting apparatus 40 can implement detection in which the hybrid light source serves as the emit end, to reduce a visual blind spot of the detection apparatus, and enhance detection performance.

It should be understood that x, y, and z coordinates shown in embodiments of this application are example identifiers provided for ease of understanding, and are not intended to limit embodiments of this application.

The following provides some possible designs based on the emitting apparatus shown in FIG. 4. The following plurality of designs may be separately implemented, or may be implemented in combination. For ease of understanding, an implementation of a combination case is also described below by using an example. The following first separately describes some possible designs.

In a possible design, the first emitting module includes an edge-emitting laser, and the second emitting module includes a vertical surface emitting laser.

When a vertical surface emitter is disposed on the circuit board, an out-light surface is a surface parallel to the circuit board. Therefore, an out-light direction of the vertical surface emitter is a direction away from the circuit board. The vertical surface emitter includes but is not limited to a vertical cavity surface emitting laser (vertical cavity surface emitting laser, VCSEL), a photonic crystal surface emitting semiconductor laser (photonic crystal surface emitting semiconductor lasers, PCSEL), or the like.

When the edge-emitting laser (edge-emitting laser, EEL) is disposed on the circuit board, an out-light surface is a side of the laser. Therefore, an out-light direction of the edge-emitting laser is a direction parallel to the circuit board. Optionally, the EEL may alternatively be another apparatus that emits light at an edge of a light emitting component, for example, a silicon photonic chip.

This is not limited to the foregoing design. In another possible design, the first emitting module includes an edge-emitting laser, and the second emitting module includes an edge emitter and a second optical module.

FIG. 6 is a diagram of a structure of another possible emitting apparatus according to an embodiment of this application. A second emitting module in an emitting apparatus 60 includes a laser 601 and a second optical module 602. An out-light surface of the laser 601 is a side surface of the laser, and a second light beam is obtained after signal light emitted by the laser 601 is deflected by the second optical module 602. The second light beam diverges away from a circuit board 403. That is, the second light beam and a third light beam face a same direction.

Optionally, a first optical module 404 and the second optical module 602 may be a same optical module.

As mentioned above, both the second light beam and the third light beam diverge away from the circuit board.

This is not limited to the foregoing design. In a possible design, an optical axis of the third light beam is coaxial with an optical axis of the second light beam, or an optical axis of the third light beam has a bias relative to an optical axis of the second light beam. The optical axis is a center line of a light beam (or a light column), or an axis of symmetry of an optical system (including an emitting apparatus, an optical module, or the like).

The following separately provides example descriptions of two possible cases.

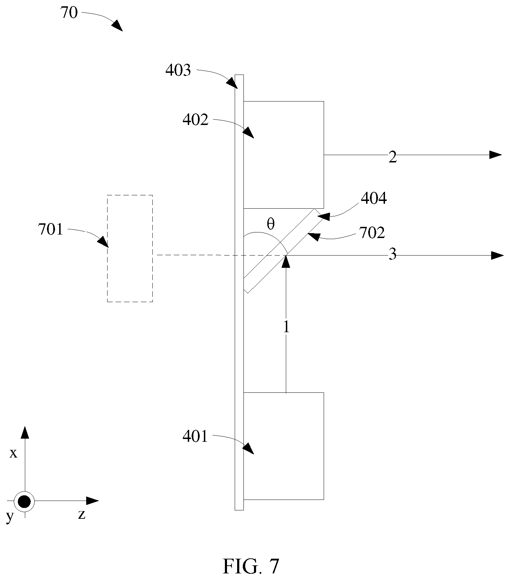

Case 1: The third light beam and the second light beam are coaxial. FIG. 7 is a diagram of a structure of another possible emitting apparatus according to an embodiment of this application. In an emitting apparatus 70 shown in FIG. 7, an optical axis of a third light beam is perpendicular to a circuit board 403, and an optical axis of a second light beam is perpendicular to the circuit board 403. Therefore, the optical axis of the third light beam is parallel to the optical axis of the second light beam, that is, is coaxial.

Light beams emitted by an emit end are coaxial, so that a diameter of an optical lens can be reduced, complexity of a component design is reduced, and stability of an optical path is improved.

In the emitting apparatus 70 shown in FIG. 7, a first optical module 404 includes a reflective surface 702, and the reflective surface 702 is configured to change a direction of a first light beam. An included angle θ between the reflective surface 702 and the circuit board is 45°. In this case, an equivalent light source of the third light beam is a light source 701, and an equivalent out-light surface of the light source 701 is parallel to the circuit board. If a second emitting module includes a vertical surface emitter, an out-light surface of the second emitting module 402 is parallel to the circuit board. Therefore, the equivalent out-light surface of the light source 701 is parallel to an equivalent out-light surface of the second emitting module 402, and the optical axis of the third light beam is parallel to the optical axis of the second light beam.

It should be noted that "parallel", "coaxial", "angle", and the like described in embodiments of this application may be relative. In a specific implementation process, an error may exist due to a manufacturing process, a mounting process, vibration, component aging, and the like. In addition, the equivalent light source described in embodiments of this application is a virtual light source that is made to facilitate understanding of technical effects of the optical path and an optical element, and does not exist in an actual running process of the emitting apparatus

Case 2: The optical axis of the third light beam has a bias relative to the optical axis of the second light beam. Optionally, the bias may be slight, for example, not greater than 45°, or less than 25°, or less than 10°.

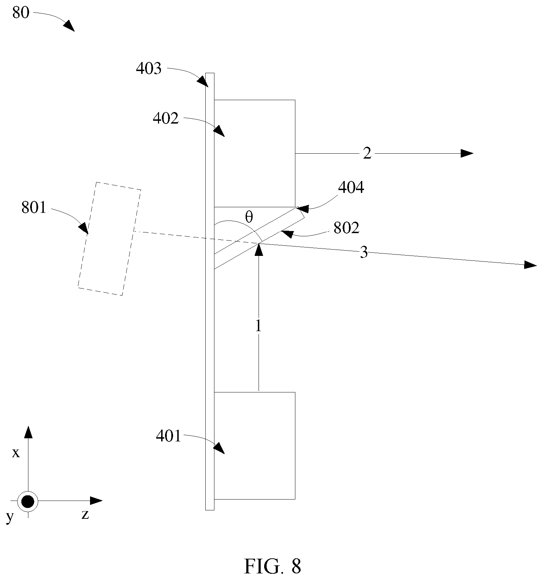

In a possible implementation, the bias may be toward a direction of the first emitting module. FIG. 8 is a diagram of a structure of another possible emitting apparatus according to an embodiment of this application. In an emitting apparatus 80 shown in FIG. 8, a third light beam diverges away from a circuit board 403, and has a bias toward a first emitting module, so that an edge of a light beam 3 is more parallel to an edge of a light beam 2, to further reduce an out-light gap between a second light beam and the third light beam.

Optionally, an angle of the bias is related to a distance between an out-light edge of the third light beam and an out-light edge of the second light beam. For example, because an out-light edge of a first emitting module 401 and an edge of a first optical module 404 can hardly completely fit each other, there is also a distance between the out-light edge of the third light beam and an edge that is of the first optical module and that is close to the second emitting module, that is, there is a distance between the out-light edge of the third light beam and the out-light edge of the second light beam. The third light beam is slightly deflected (for example, by not greater than 45°) toward the direction of the first emitting module, so that an equivalent light source 801 of the third light beam is closer to the second emitting module, and an included angle between the third light beam and the second light beam is smaller, or the third light beam and the second light beam are parallel but have a reduced spacing.

In a possible implementation, a bias between the optical axis of the third light beam and the optical axis of the second light beam may be implemented by using a placement manner of the first optical module. For example, as shown in FIG. 8, a reflective surface 802 of the first optical module 404 is configured to change a direction of a first light beam to obtain a third light beam. When an included angle θ between the reflective surface 802 and the circuit board is greater than 45°, a bias exists between the optical axis of the third light beam and the optical axis of the second light beam.

This is not limited to the foregoing design. In another possible design, a distance between the third light beam and the second light beam is less than a distance between the first emitting module and the second emitting module. A smaller distance between the third light beam and the second light beam indicates a smaller out-light gap, to help ensure a continuous visual field, and narrow a blind spot.

Optionally, the distance between the third light beam and the second light beam may be represented in the following manners:
Manner 1: When the optical axis of the third light beam is parallel to the optical axis of the second light beam, the distance between the third light beam and the second light beam may be represented as a distance between the optical axis of the third light beam and the optical axis of the second light beam.

In this manner, the distance between the optical axis of the third light beam and the optical axis of the second light beam is less than the distance between the first emitting module and the second emitting module. Optionally, the distance between the first emitting module and the second emitting module may be a distance between a center of the first reflection module and a center of the second emitting module; or optionally, a distance between an edge of the first emitting module and an edge of the second emitting module.

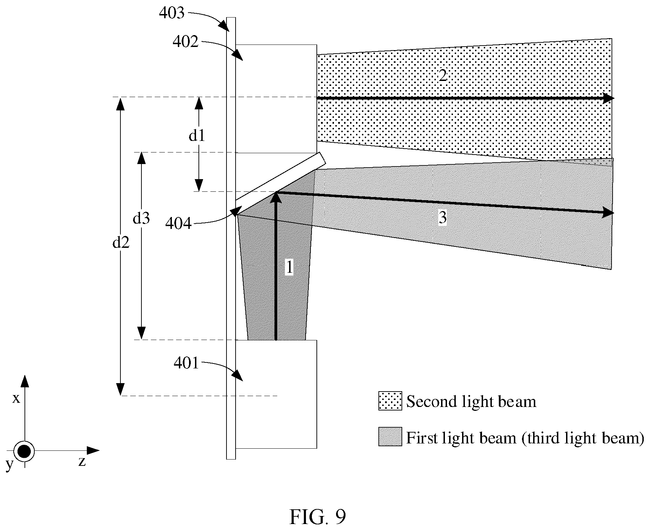

Manner 2: The distance between the third light beam and the second light beam may represent a distance between an out-light center of the third light beam and an out-light center of the second light beam. For example, FIG. 9 is a diagram of a light beam distance according to an embodiment of this application. The out-light center of the third light beam (namely, a shadow part marked 3) is a light spot center formed by the first light beam on the first optical module 404, an out-light center of the second light beam (namely, a shadow part marked 2) is a center of an out-light surface of the second emitting module 402, and the distance between the third light beam and the second light beam is the distance between the out-light center of the third light beam and the out-light center of the second light beam, namely, d1 shown in FIG. 9.

Optionally, the distance between the first emitting module and the second emitting module may be the distance between the center of the first emitting module 401 and the center of the second emitting module 402, for example, d2 shown in FIG. 9. Herein, d2>d1. Certainly, FIG. 9 is illustrated by using an example in which the center of the second emitting module 402 coincides with the out-light center of the second light beam. In a specific implementation, the center of the second emitting module 402 may not coincide with the out-light center of the second light beam.

Alternatively, optionally, the distance between the first emitting module and the second emitting module may be a distance between an edge of the first emitting module 401 and an edge of the second emitting module 402, for example, d3 shown in FIG. 9. Herein, d3>d1. Certainly, FIG. 9 is illustrated by using an example of a distance between two edges that are of the first emitting module and the second emitting module and that are close to each other. In a specific implementation, the edges may be edges far away from each other or edges in a same direction. Details are not described herein.

Manner 3: The distance between the third light beam and the second light beam may represent the distance between the out-light edge of the third light beam and the out-light edge of the second light beam. Optionally, the out-light edges may be edges that are of the third light beam and the second light beam and that are close to each other, or edges that are of the third light beam and the second light beam and that are away from each other, or edges in a same direction.

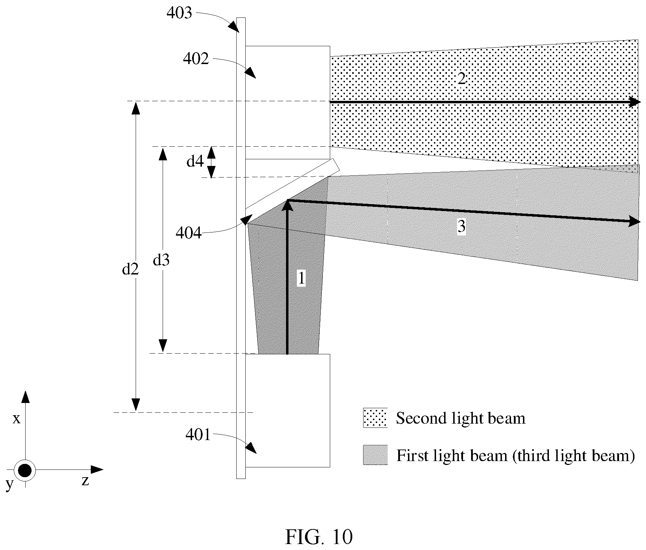

For example, FIG. 10 is a diagram of another light beam distance according to an embodiment of this application. A lower edge of the out-light edge of the second light beam (namely, a shadow part marked 2) is close to the third light beam, and an upper edge of the out-light edge of the third light beam (namely, a shadow part marked 3) is close to the second light beam. The distance between the third light beam and the second light beam may represent a distance between the upper edge of the third light beam and the lower edge of the second light beam, namely, d4 shown in FIG. 10.

Herein, d2>d4, and/or d3>d4. For related descriptions, refer to the descriptions in Manner 2.

Manner 4: The distance between the third light beam and the second light beam may be a pointing angle difference.

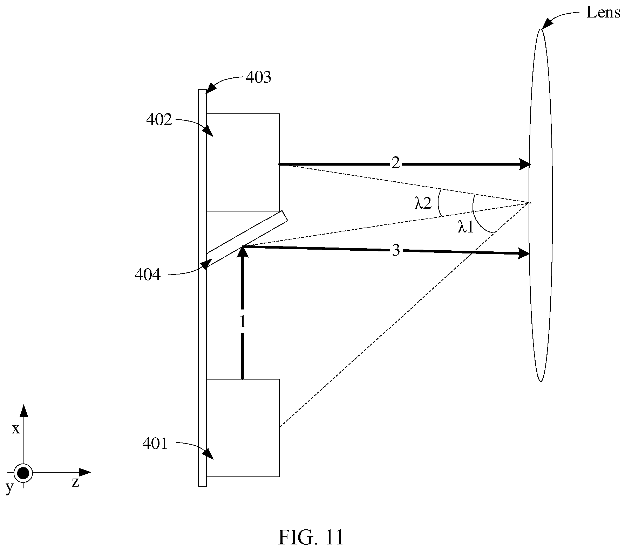

For example, when the emitting apparatus further includes a lens, the distance between the third light beam and the second light beam may be represented as an included angle between the out-light center of the first light beam and the out-light center of the second light beam relative to the lens center (or an optical center of the lens). FIG. 11 is a diagram of another optical path according to an embodiment of this application. The emitting apparatus further includes a lens. λ2 is an included angle between the out-light center of the first light beam and the out-light center of the second light beam relative to the lens center. λ1 is an included angle between the first emitting module and the second emitting module relative to the lens center. λ2 is less than λ1.

The foregoing four manners are examples provided for ease of understanding. In addition, cases shown in FIG. 9 to FIG. 11 are also several possible optical path examples. In a specific implementation process, a specific error may exist in the optical path due to a component placement location, a manufacturing process, a mounting process, vibration, component aging, and the like.

This is not limited to the foregoing design. In another possible design, the emitting apparatus further includes a lens, and the lens is configured to: process the third light beam to obtain a fourth light beam, and process the second light beam to obtain a fifth light beam. The second light beam and the third light beam are emitted by using a same lens, so that a volume of an emitting apparatus can be reduced, and component integration can be improved.

The lens is an optical element that has a convergence effect on light, for example, a convex lens or a Meniscus lens. In some scenarios, the lens may further have a collimation function, for example, a collimating lens group.

Optionally, a principal axis of the lens may coincide with the center of the second emitting module. Further, coinciding may be partially coinciding in some dimensions, for example, coinciding in an x direction.

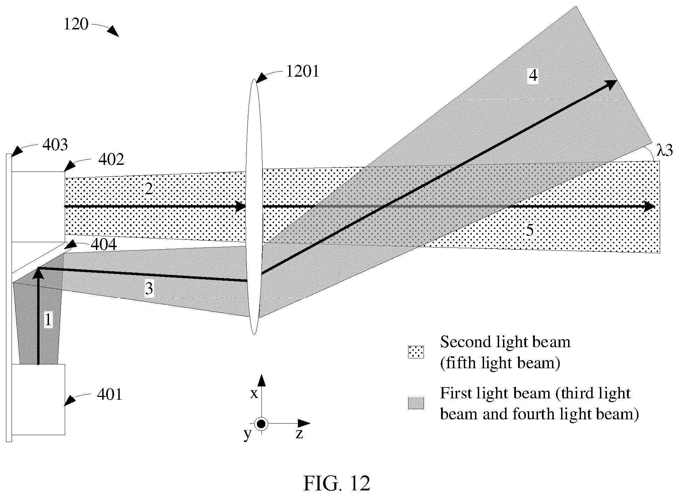

FIG. 12 is a diagram of a structure of another possible emitting apparatus according to an embodiment of this application. An emitting apparatus 120 includes a lens 1201. After a third light beam (namely, a shadow part marked 3) passes through the lens, a fourth light beam (namely, a shadow part marked 4) is obtained. After a second light beam (namely, a shadow part marked 2) passes through the lens, a fifth light beam (namely, a shadow part marked 5) is obtained. Optionally, an included angle between the fourth light beam and the fifth light beam is λ3.

In another possible implementation, a visual field gap between the fourth light beam and the fifth light beam is less than a first angle, and the first angle is an included angle between a first emitting module and a second emitting module relative to the lens.

With reference to FIG. 11 and FIG. 12, λ3 is the visual field gap between the fourth light beam and the fifth light beam, λ1 is an included angle between the first emitting module and the second emitting module relative to a lens center, and λ3<λ1.

With reference to FIG. 3, it is easily learned that, in a case of a plurality of light sources, because electrical performance isolation between light sources causes a large angular gap (an angle γ shown in FIG. 3) between optical signals of two light sources. According to the solution in this embodiment of this application, a visual field gap (λ3<γ) between light beams emitted by two emitting modules can be greatly reduced, to expand a coverage area, and narrow a visual blind spot.

In a possible implementation, the fourth light beam and the fifth light beam have a continuous visual field. In some scenarios, a visual field between the fourth light beam and the fifth light beam may be continuous through reflection, refraction, or the like. For example, the third light beam is deflected, so that an optical axis of the fourth light beam is parallel to an optical axis of the fifth light beam, a gap between edges is close to 0, and the visual field between the fourth light beam and the fifth light beam is continuous.

The continuous visual field or a reduced visual field gap may further narrow the visual blind spot, and improve detection efficiency and reliability of a detection result.

In a possible implementation, the visual field gap between the fourth light beam and the fifth light beam is related to the distance between the second emitting module and the first optical module. The visual field gap of the emit end may be controlled by adjusting the distance between the first optical module and the second emitting module. The manufacturer or the developer may flexibly set the location of the first optical module according to a requirement, to improve compatibility of the emitting apparatus with different scenarios.

For example, edges of the first emitting module and the second optics are closely attached, or a spacing is small, so that the visual field gap of the emit end can be reduced, and a visual blind spot can be narrowed.

This is not limited to the foregoing design. In another possible design, the second emitting module is located on a focal plane of the lens. Alternatively, further, the second emitting module includes an out-light surface, and the second emitting module is located on a focal plane of the lens.

The second emitting module is disposed on the focal plane, so that a light beam emitted by the second emitting module has a good collimation degree when passing through the lens, to improve a longest detection range of the detection apparatus, and ensure a long-range detection capability.

This is not limited to the foregoing design. In another possible design, the first emitting module is defocused to some extent relative to the focal plane of the lens. As shown in FIG. 7, the first emitting module is equivalent to the light source 701, and the light source 701 is defocused to some extent relative to the focal plane of the lens.

The second emitting module is defocused, so that the third light beam presents a dispersion effect to some extent, and the third light beam obtained after the lens is passed may have a larger visual field, to narrow a blind spot.

Optionally, a defocusing amount corresponding to the first emitting module is related to the distance between the first optical module and the first emitting module. For example, when the second emitting module is disposed on the focal plane of the lens, a longer distance between the second emitting module and the first optical module indicates a larger defocusing amount corresponding to the first emitting module. In such a setting, the distance between the first optical module and the first emitting module is adjusted, so that the defocusing amount of the first emitting module can be controlled. The manufacturer or the developer may flexibly set the location of the first optical module according to a requirement, to improve compatibility of the emitting apparatus with different scenarios.

In a possible implementation, the first optical module includes a reflective surface, the reflective surface is configured to change the direction of the first light beam to obtain the third light beam, and a mirror surface of the first reflective surface is a convex spherical surface. The convex spherical surface is used to compensate for a relative defocusing amount of the first emitting module, to improve a collimation degree of the third light beam, and improve a long-range detection capability.

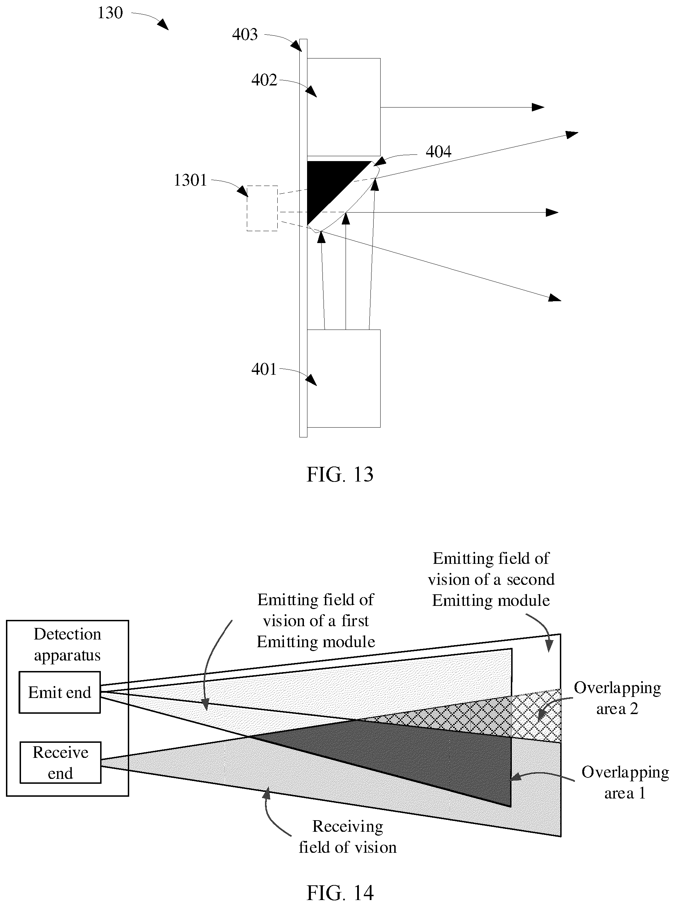

FIG. 13 is a diagram of a structure of another possible emitting apparatus according to an embodiment of this application. A first optical module 404 in an emitting apparatus 130 shown in FIG. 13 is configured to change a mirror surface of a reflective surface of a first light beam from a first emitting module 401 to a convex spherical surface, so that a light beam obtained after the first light beam passes through the first optical module 404 has a larger field of view.

In addition, an equivalent light source of a third light beam may be considered as a light source 1301. Because the third light beam diverges compared with the first light beam, a distance between the first optical module and the equivalent light source 1301 is less than a distance between the first optical module and the first emitting module, and a defocusing amount of the first emitting module relative to a lens is compensated for, so that a long-range detection capability can be improved.

This is not limited to the foregoing design. In another possible design, the first light beam and the second light beam have different longest detection ranges.

For example, a longest detection range of the first light beam is less than a longest detection range of the second light beam. For another example, a longest detection range of the second light beam is less than a longest detection range of the first light beam.

The following provides descriptions by using an example in which the longest detection range of the first light beam is small.

When the longest detection range of the first light beam is less than the longest detection range of the second light beam, the second light beam is applicable to long-range detection, and the first light beam is applicable to short-range detection. Therefore, a light beam emitted by the first emitting module may detect a blind spot formed during long-range detection by using a hybrid light source, to improve a short-range detection capability of a detection apparatus, and enhance detection performance of the detection apparatus.

In a possible implementation, that the longest detection range of the first light beam is less than the longest detection range of the second light beam may be implemented in the following manners:

Implementation 1: Energy density of the first light beam is less than energy density of the second light beam. Energy density of a signal is related to a longest detection range of the signal. Smaller capability density indicates a smaller longest detection range. Therefore, the first light beam is applicable to short-range detection. In addition, the longest detection range of the first light beam is short, so that mutual interference between short-distance detection and longdistance detection can be avoided, short-range detection accuracy and long-range detection accuracy of the detection apparatus are improved, and detection performance is improved.

Implementation 2: Power of the first light beam is less than power of the second light beam. A power of a signal is related to a longest detection range of the signal. A smaller power indicates a smaller longest detection range. Therefore, the first light beam is applicable to short-range detection.

The foregoing implementations are merely examples. In a specific implementation case, the first optical module may be set to be defocused, the first light beam may be set to be diverged, or the like, so that the first light beam is applicable to short-range detection and/or detection for blind spot compensation.

In a possible implementation, when the second emitting module is configured to perform short-range detection, a visual field of the second emitting module can be expanded by setting the second emitting module and the lens to be defocused relative to each other, to increase a short-range detection range, and further reduce a visual blind spot.

This is not limited to the foregoing design. In another possible design, the first emitting module and the second emitting module are configured to emit light beams in a time division manner, and the first light beam and the second light beam have different transmission time. In such a setting, transmission time of the first light beam and transmission time of the second light beam are alternate, so that it is difficult to form mutual interference when targets in different visual fields are detected.

FIG. 14 is a diagram of a detection range according to an embodiment of this application. It can be learned that an overlapping area between an emitting field of vision of the first emitting module and a receiving field of vision is an overlapping area 1, and an overlapping area between an emitting field of vision of the second emitting module and the receiving field of vision is an overlapping area 2. The overlapping area 1 and the overlapping area 2 overlap. When the first emitting module and the second emitting module perform detection in a time division manner, the overlapping area 1 and the overlapping area 2 are isolated in a time division manner, to reduce mutual interference, and improve an effective proportion of signals received by a detection apparatus.

Optionally, when the first light beam and the second light beam are respectively used for short-range detection and long-range detection, detection for blind spot compensation in a nearvisual field range is further implemented without affecting a long-range detection capability, and detection performance of the detection apparatus is enhanced.

In an example of time-division light emission, the first emitting module is configured to emit the first light beam in a first time period, the second emitting module is configured to emit the second light beam in a second time period, and the first time period and the second time period do not overlap.

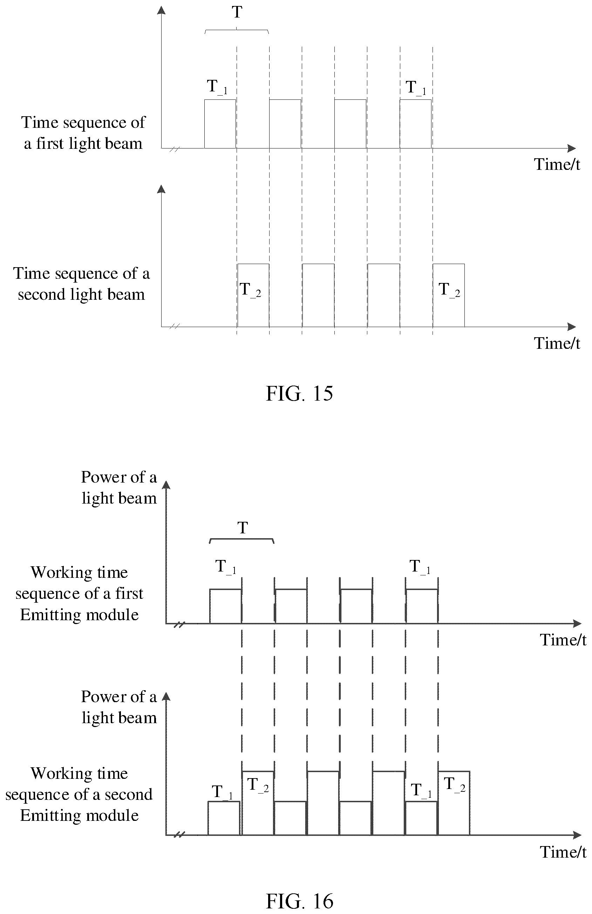

FIG. 15 is a diagram of a light emitting time sequence according to an embodiment of this application. As shown in FIG. 15, in a detection cycle T, the first light beam is emitted in a time period T_{_1} in the cycle, and a second light beam is emitted in a time period T_{_2} in the cycle. The time period T_{_1} and the time period T_{_2} do not overlap. Certainly, the light emitting time sequence shown in FIG. 15 is described by using a periodic light emitting time sequence as an example. This application is also applicable to aperiodic light emitting or periodic light emitting with another duration rule. For example, duration of the time period T_1 may be different from duration of the time period T_2. For example, the duration of the time period T_1 may be greater than the duration of the time period T_2, or the duration of the time period T_1 may be less than the duration of the time period T_2. For example, after a plurality of time periods T_1 and a plurality of time periods T_2, the first emitting module and the second emitting module may pause for a period of time, and then start to emit light again.

It should be noted that a vertical coordinate in FIG. 15 is an example indicating whether there is a light beam at specific time, and a variable is not strictly limited. For example, the variable indicated by the vertical coordinate may indicate whether an emitting module is powered on, a level of the emitting module, or a power of signal light emitted by the emitting module.

In a possible implementation, in the second time period, the second emitting module may emit a sixth light beam, and a longest detection range of the sixth light beam is different from a longest detection range of the second light beam.

For example, when a longest detection range of the first light beam is less than the longest detection range of the second light beam, the longest detection range of the sixth light beam is less than the longest detection range of the second light beam. In such a setting, the sixth light beam is applicable to short-range detection in the first time period. In this way, short-range detection can be performed in a larger range in the first time period, to further improve a short-range detection capability of the detection apparatus. Optionally, a range detection capability of the sixth light beam is equal to a range detection capability of the first light beam.

FIG. 16 is a diagram of another light emitting time sequence according to an embodiment of this application. As shown in FIG. 16, in a detection cycle T, the first emitting module emits the first light beam in a time period T_{_1} in the cycle, the second emitting module emits the sixth light beam in a time period T_{_1} in the cycle, and the second emitting module emits the second light beam in a time period T_{_2} in the cycle. A longest detection range of the first light beam is less than a longest detection range of the second light beam, and a longest detection range of the sixth light beam is also less than a longest detection range of the second light beam. Therefore, in the time period T_{_1}, light beams emitted by the first emitting module and the second emitting module may be considered as light beams used for short-range detection; and in the time period T_2, light beams emitted by the second emitting module may be considered as light beams used for long-range detection. In such a setting, time of long-range detection and time of short-range detection are isolated, and short-range detection in a larger range is further implemented. This further improves detection efficiency, improves the short-range detection capability of the detection apparatus, and enhances detection performance.

It should be noted that a vertical coordinate "power" in FIG. 16 is an example for indicating a longest detection range of a light beam in a time period. The power may alternatively be a current of an emitting module, energy density of a light beam, a longest detection range of the light beam, or the like.

This is not limited to the foregoing design. In another possible design, the first emitting module includes a plurality of first lasers (for example, N first lasers, where N is an integer and N>0), the second emitting module includes a plurality of second lasers (for example, M second lasers, where N is an integer and M>0), and the first emitting module and the second emitting module are distributed along a first direction.

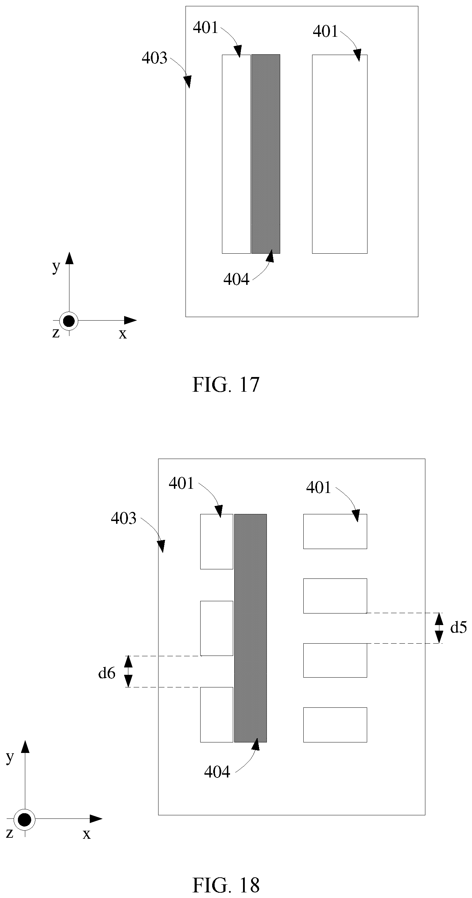

In a possible implementation, M=1, and N=1. FIG. 17 is a diagram of a structure of another possible emitting apparatus according to an embodiment of this application. A first emitting module 401 and a second emitting module 402 are arranged along an x direction. The first emitting module 401 includes one laser, and an out-light direction of the laser is a direction away from a circuit board, namely, a z direction. The second emitting module 402 includes one laser, and an out-light direction of the laser is parallel to a direction of the circuit board, namely, an x direction. The emitting module includes one laser, so that there is no gap, in a second direction (for example, a y direction), between light beams emitted by the emitting module, to improve a continuous visual field in the second direction.

In another possible implementation, N>1, and M>1. The N first lasers are spaced apart in a second direction, and the second direction is perpendicular to the first direction; and the N second lasers are spaced apart in the second direction.

FIG. 18 is a diagram of a structure of a possible emitting apparatus according to an embodiment of this application. A first emitting module 401 and a second emitting module 402 are arranged along an x direction. The first emitting module 401 includes four lasers, and an out-light direction of the first emitting module 401 is a direction away from a circuit board, namely, a z direction. The second emitting module 402 includes three lasers, and an out-light direction of the three lasers is a direction parallel to the circuit board, namely, an x direction.

Because a laser with a large out-light surface has high manufacturing difficulty and high costs, a plurality of separated lasers may be disposed to reduce costs. The plurality of separated lasers may further reduce heat dissipation pressure, avoid a high-temperature hotspot on the circuit board, and improve a service life.

In a possible implementation, a gap (d5 shown in FIG. 18) between first lasers is less than a gap (d6 shown in FIG. 18) between second lasers.

In a possible implementation, the emitting apparatus further includes a light homogenizing component, and the light homogenizing component is configured to perform homogenizing on a light beam from the first emitting module and a light beam from the second emitting module in the second direction. The light homogenizing component is used, so that a gap between lasers in the y direction is filled, to further reduce a visual blind spot.

Optionally, the light homogenizing component may be implemented by using an apparatus such as a microlens array, a light homogenizing panel, a light homogenizing sheet, or a diffusion plate.

The foregoing describes some possible designs in embodiments of this application. In a specific implementation process, the foregoing plurality of designs may be further combined. The following provides example descriptions of a combination of some designs. It should be understood that, for modules and logic that are not explained in the following embodiments, refer to descriptions in the foregoing design. The following embodiments may be combined.

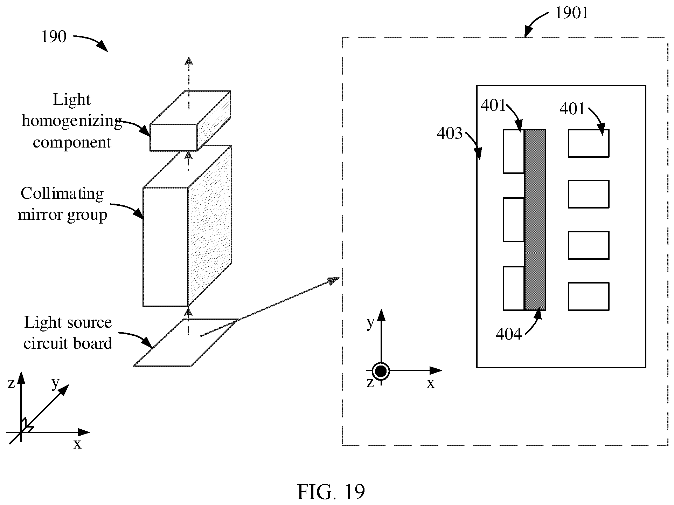

FIG. 19 is a diagram of a structure of another possible emitting apparatus according to an embodiment of this application. An emitting apparatus 190 includes a circuit board and a collimating lens group, and optionally includes a light homogenizing component, a reflective mirror, or the like. Optionally, the light homogenizing component is implemented by using a microlens array.

A first emitting module 401 and a second emitting module 402 are disposed on a light source circuit board 403. An out-light direction of the first emitting module 401 is a direction (for example, a z direction) away from the circuit board, and an out-light direction of the second emitting module 402 is a direction (for example, an x direction) parallel to the circuit board. A first optical module 404 is placed between the first emitting module and the second emitting module, so that light sources emit light in a same direction.

A distribution of the first emitting module and the second emitting module on an x-y plane is shown in an area 1901. A plurality of first emitters included in the first emitting module are distributed along a y direction and there is a gap between two first emitters; and a plurality of second emitters included in the second emitting module are distributed along the y direction and there is a gap between two second emitters. Optionally, edges of the first emitting module and the second emitting module in the y direction are aligned.

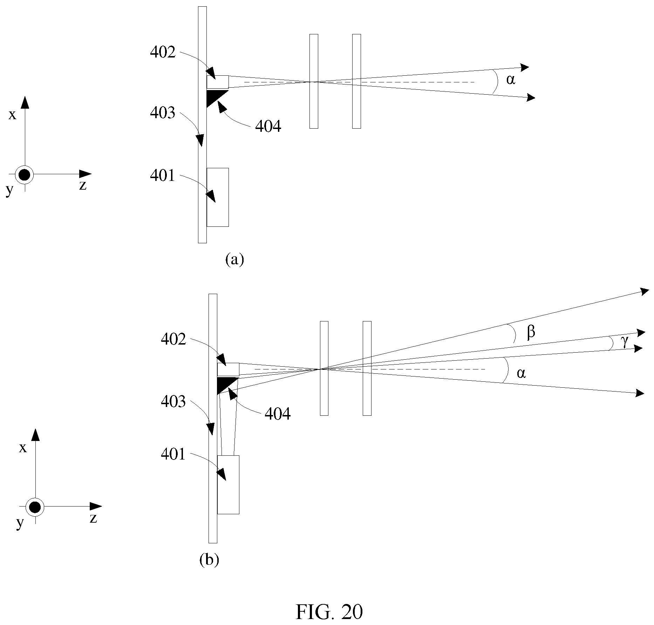

FIG. 20 is a diagram of a field of view of an emitting apparatus according to an embodiment of this application. As shown in a part (a) in FIG. 20, in the x direction, after a second light beam emitted by the second emitting module 402 passes through a collimating lens group and a light homogenizing component (optional), a field of view in the x direction is α. As shown in a part (b) in FIG. 20, after a first light beam emitted by the first emitting module 401 passes through the first optical module 404, the collimating lens group, and the light homogenizing component (optional), a field of view in the x direction is β. There is a gap of γ between α and β. Because a distance between the first optical module 404 and the second emitting module 402 is short, γ is significantly reduced, a visual blind spot of the detection apparatus is narrowed, detection efficiency is improved, and detection performance is enhanced.

In a possible implementation, in the y direction, the light homogenizing component may perform homogenizing on the first light beam and the second light beam, to implement a continuous visual field of the emitting apparatus in the y direction.

In a possible implementation, the first optical module 404 deflects an optical path, so that an equivalent back focal location of the first emitting module 401 is longer than that of the second emitting module 402. In the z direction, the second emitting module 402 is located on a focal plane of the collimating lens group, and the first emitting module 401 has a specific defocusing distance.

In a possible implementation, in a cycle T, the first emitting module emits the first light beam in T1, the second emitting module emits a sixth light beam in T1, as shown in the part (b) in FIG. 20, and the second emitting module emits the second light beam in T2, as shown in the part (a) in FIG. 20. The first light beam and the sixth light beam are used for short-range detection, and the second light beam is used for long-range detection. Such a light emitting manner can expand a visual field of short-range detection, improve detection efficiency, and enhance detection performance.

The embodiment shown in FIG. 19 may be further combined with one or more of the foregoing designs. Combination cases are not described in detail one by one in this application.

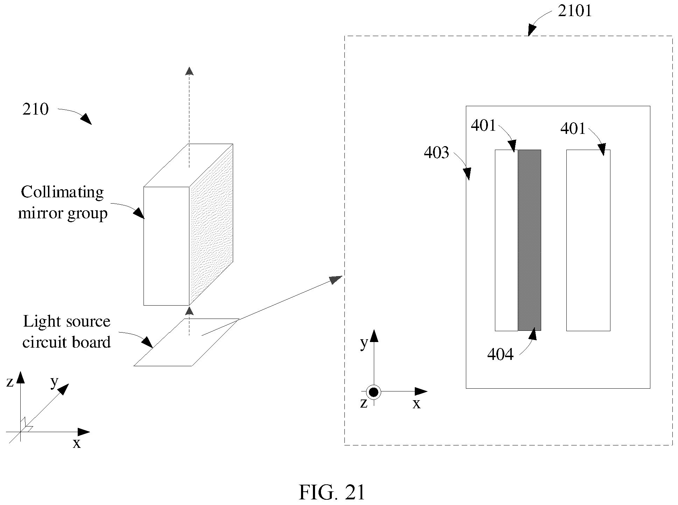

FIG. 21 is a diagram of a structure of another possible emitting apparatus according to an embodiment of this application. An emitting apparatus 210 includes a light source circuit board 403 and a collimating lens group. A first emitting module 401 and a second emitting module 402 are disposed on the light source circuit board 403, and a distribution of the first emitting module and the second emitting module on an x-y plane is shown in an area 2101.

The first emitting module 401 and the second emitting module 402 each include a longstrip light source. An out-light direction of the first emitting module 401 is a direction (for example, a z direction) away from the circuit board, and an out-light direction of the second emitting module 402 is a direction (for example, an x direction) parallel to the circuit board. A first optical module 404 is placed between the first emitting module and the second emitting module, so that light sources emit light in a same direction.

Optionally, edges of the first emitting module and the second emitting module in the y direction are aligned. The first optical module 404 is disposed, so that a gap between light beams emitted by the first emitting module and the second emitting module is significantly reduced, a visual blind spot of a detection apparatus is narrowed, detection efficiency is improved, and detection performance is enhanced.

The first optical module 404 in the emitting apparatus 210 may be a reflective mirror with a convex spherical surface, and a mirror surface with a convex spherical surface may compensate for a defocusing amount of the first emitting module, to improve long-range detection performance.

For example, the reflective mirror with a convex spherical surface is closely attached to the second emitting module 402, and an angle of inclination of the reflective mirror with a convex spherical surface may be 45°, so that an optical axis of the first emitting module 401 may be deflected to be parallel to an optical axis of the collimating lens group, and a light beam emitted by the first emitting module 401 and a light beam emitted by the second emitting module 402 are coaxial.

In a possible implementation, in the x direction, a collimation system may implement that emit light beams of the second emitting module 402 present a field of view α, and an emit light beam of the first emitting module 401 presents a field of view β. Because the first optical module 404 is closely attached to a long-range detection light source, the field of view β is closely attached to the field of view α, to implement a continuous light emitting visual field of a hybrid light source, and narrow a detection blind spot. For related descriptions, refer to the descriptions of FIG. 20.

In a possible implementation, the first optical module 404 deflects an optical path, so that an equivalent back focal location of the first emitting module 401 is longer than that of the second emitting module 402. In the z direction, the second emitting module 402 is located on a focal plane of the collimating lens group, and the first emitting module 401 has a specific defocusing distance.

In a possible implementation, in a cycle T, the first emitting module emits the first light beam in T1, the second emitting module emits the sixth light beam in T1, and the second emitting module emits the second light beam in T2. The first light beam and the sixth light beam are used for short-range detection, and the second light beam is used for long-range detection. Such a light emitting manner can expand a visual field of short-range detection, improve detection efficiency, and enhance detection performance.

The embodiment shown in FIG. 21 may be further combined with one or more of the foregoing designs. Combination cases are not described in detail one by one in this application.

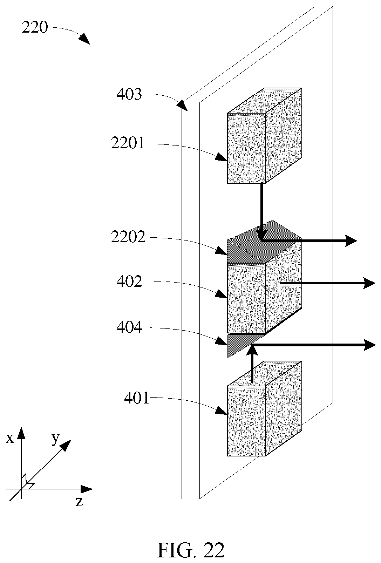

FIG. 22 is a diagram of another possible emitting apparatus according to an embodiment of this application. An emitting apparatus 220 includes a light source circuit board 403, a first emitting module 401, a second emitting module 402, and a third emitting module 2201. The light source circuit board 403 is connected to the first emitting module 401, the second emitting module 402, and the third emitting module 2201.

A first optical module 404 is disposed between the first emitting module 401 and the second emitting module 402, and the first optical module 404 is configured to change a light beam from the first emitting module 401, so that the light beam from the first emitting module 401 and a light beam from the second emitting module 402 face a same direction.

A third optical module 2202 is disposed between the third emitting module 2201 and the second emitting module 402, and the third optical module 2202 is configured to change a light beam from the third emitting module 2201, so that the light beam from the third emitting module 2201 and a light beam from the second emitting module 402 face a same direction.

The embodiment shown in FIG. 22 may be further combined with one or more of the foregoing designs. Combination cases are not described in detail one by one in this application. In addition, for an optical path design, an element placement design, and the like of the third emitting module 2201, refer to a design of the first emitting module 401. Details are not described herein again.

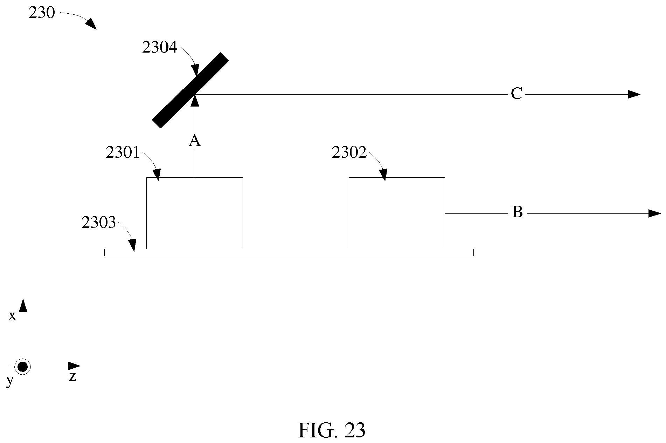

FIG. 23 is a diagram of a structure of another possible emitting apparatus according to an embodiment of this application. An emitting apparatus 230 includes a first emitting module 2301, a second emitting module 2302, a circuit board 2303, and an optical module 2304.

The first emitting module 2301 emits a light beam (referred to as a light beam A for ease of distinguishing) in a direction away from the circuit board 2303, and the second emitting module 2302 emits a light beam (referred to as a light beam B for ease of distinguishing) in a direction parallel to the circuit board 2303. The optical module 2304 is disposed in an out-light direction of the first emitting module 2301, and is configured to change a direction of a light beam from the first emitting module 2301, to obtain a light beam (referred to as a light beam C for ease of distinguishing) facing another direction, so that the light beam C and the light beam B face a same direction.

Light sources (namely, a hybrid light source) in different out-light directions emit light in a same direction by using the emitting apparatus shown in FIG. 23.

In a possible design, a distance between the optical module 2304 and the first emitting module 2301 is less than a distance between the first emitting module 2301 and the second emitting module 2302. Correspondingly, a distance between a light beam C and a light beam B is less than a distance between the first emitting module 2301 and the second emitting module 2302, so that the light beam C and the light beam B are adjacent, to reduce an out-light gap between different light sources when a plurality of light sources output light.

In conclusion, the light beam C and the light beam B face a same direction and a distance is greatly shortened, so that a visual blind spot of the detection apparatus can be reduced.

The embodiment shown in FIG. 23 may be further combined with one or more of the foregoing designs. Combination cases are not described in detail one by one in this application.

An embodiment of this application further provides a detection apparatus. The detection apparatus includes an emitting apparatus and a detector. The emitting apparatus is the emitting apparatus described in the foregoing embodiments, for example, one or more of the emitting apparatus 40, the emitting apparatus 60, the emitting apparatus 70, the emitting apparatus 80, the emitting apparatus 120, the emitting apparatus 130, the emitting apparatus 190, the emitting apparatus 210, the emitting apparatus 220, or the emitting apparatus 230.

For example, a first emitting module in the emitting apparatus is configured to emit a first light beam, and a second emitting module in the emitting apparatus is configured to emit a second light beam. The detector is configured to receive an echo signal corresponding to the first light beam and an echo signal corresponding to the second light beam.

An embodiment of this application further provides a terminal. The terminal includes the foregoing emitting apparatus and/or the foregoing detection apparatus.

Optionally, the terminal may be an intelligent terminal such as a vehicle, an uncrewed aerial vehicle, or a robot, or a transportation tool.

In the descriptions of this application, orientation or location relationships indicated by the terms "center", "upper", "lower", "vertical", "horizontal", "inside", "outside", and the like are orientation or location relationships based on the accompanying drawings, and are merely intended for ease of describing this application and simplifying description, but does not indicate or imply that an indicated apparatus or element needs to have a specific orientation or needs to be construed and operated in a specific orientation. Therefore, such terms should not be understood as a limitation on this application.

In addition, a Cartesian coordinate system and directions x, y, and z shown in embodiments of this application are example identifiers for ease of understanding, and are not intended to limit embodiments of this application. In a specific implementation process, there may be another design for a placement manner, an arrangement direction, and an orientation of a light beam of the device, and another coordinate system such as a spherical coordinate system may also be used as a coordinate system.

In embodiments of this application, the word such as "example" or "for example" is used to represent giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

In embodiments of this application, "at least one" means one or more, and "a plurality of" means two or more. The expression "at least one of the following items (pieces)" or a similar expression thereof indicates any combination of these items, including a single item (piece) or any combination of a plurality of items (pieces). For example, at least one of a, b, or c may indicate: a, b, c, (a and b), (a and c), (b and c), or (a, b, and c), where a, b, and c may be singular or plural. The term "and/or" describes an association between associated objects, and indicates that three relationships may exist. For example, A and/or B may indicate the following three cases: Only A exists, both A and B exist, and only B exists, where A and B may be singular or plural. The character "/" usually indicates an "or" relationship between the associated objects.

In addition, unless otherwise stated, ordinal numbers such as "first" and "second" in embodiments of this application are for distinguishing between multiple objects, but are not intended to limit an order, a time sequence, priorities, or importance of the multiple objects. For example, a first emitting module and a second emitting module are merely for ease of description, and do not indicate different light emitting manners, light emitting sequences, importance degrees, or the like of the first emitting module and the second emitting module.

## Claims

1. An emitting apparatus, wherein the emitting apparatus comprises a first emitting module, a second emitting module, a circuit board, and a first optical module;
the first emitting module and the second emitting module are electrically connected to the circuit board, and are disposed on one side of the circuit board, and the first optical module is placed between the first emitting module and the second emitting module;
the first emitting module is configured to emit a first light beam, wherein the first light beam is parallel to the circuit board;
the second emitting module is configured to emit a second light beam, wherein a direction of the second light beam diverges away from the circuit board; and
the first optical module is configured to change a direction of the first light beam to obtain a third light beam, wherein a direction of the third light beam diverges away from the circuit board.

2. The emitting apparatus according to claim 1, wherein the first emitting module comprises an edge-emitting laser, and the second emitting module comprises a vertical surface emitting laser.

3. The emitting apparatus according to claim 1 or 2, wherein an optical axis of the third light beam is coaxial with an optical axis of the second light beam, or an optical axis of the third light beam has a bias toward the first emitting module relative to an optical axis of the second light beam.

4. The emitting apparatus according to any one of claims 1 to 3, wherein a distance between the third light beam and the second light beam is less than a distance between the first emitting module and the second emitting module.

5. The emitting apparatus according to any one of claims 1 to 4, wherein the emitting apparatus further comprises a lens, and the lens is configured to: process the third light beam to obtain a fourth light beam, and process the second light beam to obtain a fifth light beam.

6. The emitting apparatus according to claim 5, wherein the fourth light beam and the fifth light beam have a continuous visual field; or
a visual field gap between the fourth light beam and the fifth light beam is less than a first angle, and the first angle is an included angle between the first emitting module and the second emitting module relative to the lens.

7. The emitting apparatus according to claim 5 or 6, wherein the second emitting module is located on a focal plane of the lens.

8. The emitting apparatus according to claim 7, wherein the first optical module comprises a reflective surface, the reflective surface is configured to change the direction of the first light beam to obtain the third light beam, and a mirror surface of the first reflective surface is a convex spherical surface.

9. The emitting apparatus according to any one of claims 1 to 8, wherein a longest detection range of the first light beam is less than a longest detection range of the second light beam.

10. The emitting apparatus according to claim 9, wherein the first emitting module and the second emitting module are configured to emit light beams in a time division manner, and the first light beam and the second light beam have different transmission time.

11. The emitting apparatus according to claim 9 or 10, wherein
the first emitting module is configured to emit the first light beam in a first time period;
the second emitting module is configured to emit the second light beam in a second time period, wherein the first time period and the second time period do not overlap; and
the second emitting module is further configured to emit a sixth light beam in the first time period, wherein a longest detection range of the sixth light beam is less than a longest detection range of the second light beam.

12. The emitting apparatus according to any one of claims 1 to 11, wherein the first emitting module comprises N first lasers, the second emitting module comprises M second lasers, N and M are integers, N>0, and M>0;
the first emitting module and the second emitting module are distributed along a first direction; the first emitting module comprises N first lasers, the second emitting module comprises M second lasers, N and M are integers, N>1, and M>1;
the N first lasers are spaced apart in a second direction, and the second direction is perpendicular to the first direction;
the N second lasers are spaced apart in the second direction; and
the emitting apparatus further comprises a light homogenizing component, and the light homogenizing component is configured to perform homogenizing on a light beam from the first emitting module and a light beam from the second emitting module in the second direction.

13. A detection apparatus, wherein the detection apparatus comprises an emitting apparatus and a detector, and the emitting apparatus comprises the emitting apparatus according to any one of claims 1 to 12;
a first emitting module in the emitting apparatus is configured to emit a first light beam, and a second emitting module in the emitting apparatus is configured to emit a second light beam; and
the detector is configured to receive an echo signal corresponding to the first light beam and an echo signal corresponding to the second light beam.

14. A terminal, wherein the terminal comprises the emitting apparatus according to any one of claims 1 to 12, or comprises the detection apparatus according to claim 13.

15. The terminal according to claim 14, wherein the terminal is a vehicle, an uncrewed aerial vehicle, or a robot.
